Europäisches Patentamt

European Patent Office

Office européen des brevets

(11) Numéro de publication: **0 188 152**
**A1**

(12) **DEMANDE DE BREVET EUROPEEN**

(21) Numéro de dépôt: 85402466.8

(22) Date de dépôt: 11.12.85

(51) Int. Cl.⁴: **H 05 K 13/00**
H 01 C 13/02, H 01 G 1/035

(30) Priorité: 20.12.84 FR 8419516

(43) Date de publication de la demande:
23.07.86 Bulletin 86/30

(84) Etats contractants désignés:
AT BE CH DE FR GB IT LI LU NL SE

(71) Demandeur: SOVCOR S.A.
113, Chemin de Ronde
F-78290 Croissy-sur-Seine(FR)

(72) Inventeur: Tradeau, Jacques André
6 Impasse Pasteur
F-78570 Andresy(FR)

(72) Inventeur: Merser, Jacques Eugène
1 Square Lavoisier
F-78330 Fontenay Le Fleury(FR)

(74) Mandataire: de Boisse, Louis et al,
CABINET DE BOISSE 37, Avenue Franklin D. Roosevelt
F-75008 Paris(FR)

(54) Composant électronique à surmoulage partiel et bande portant une pluralité de ces composants.

(57) L'invention se rapporte aux composants électroniques élémentaires pour montage à plat dans la confection industrielle de circuits électroniques.

Elle concerne un composant électronique, tel qu'une résistance miniature, pour montage en surface, du type comprenant un corps cylindrique muni d'un capot conducteur à chacune de ses extrémités, caractérisé en ce qu'il comprend en outre un surmoulage partiel enrobant la partie du corps située entre les capots conducteurs et laissant à nu au moins une partie de chaque capot conducteur, ce surmoulage présentant au moins deux facettes planes parallèles entre elles et à l'axe longitudinal dudit corps.

Application aux circuits imprimés.

- 1 -

Composant électronique à surmoulage partiel et bande
portant une pluralité de ces composants

La présente invention est relative au domaine des composants électroniques, notamment des composants électroniques miniatures pour montage en surface (souvent désigné
sous le vocable anglo-saxon de "chips"). Elle vise plus
spécialement leur réalisation industrielle conçue en vue
de leur report à plat pour la confection de circuits
imprimés.

On sait que le marché dit grand public (récepteurs de télévision et radio, magnétoscopes...) utilise des millions de
composants miniatures pour montage en surface, lesquels se
présentent toutefois sous forme cylindrique ou tubulaire
--c'est-à-dire de section droite circulaire-- bien adaptée
aux machines de placement simultané (multiplacing) alimentées par flexibles dont les cadences horaires élevées
(50.000 à 100.000 pièces) sont compatibles avec les fabrications en très grande série du domaine grand public.

Quant au marché dit professionnel (téléphonie, avionique,
instrumentation, calculateurs...), il est en train d'opérer sa conversion vers le montage en surface, mais les équipements fabriqués ne sont lancés qu'en petites séries comparativement au marché grand public et, dans ce secteur professionnel, les fabricants d'équipements souhaitent vivement s'orienter vers des machines de report plus souples permettant la manutention de composants susceptibles d'être montés en surface à partir d'une mise sur bande au format cinématographique "super 8".

Ces machines ne peuvent cependant travailler qu'avec des composants pour montage en surface présentant une section rectangulaire (en anglais "rectangular chip"). Ces composants rectangulaires présentent, en effet, deux faces planes principales parallèles dont l'une (la face supérieure) permet la préhension du composant par une pipette d'aspiration de la machine et l'autre (la face inférieure) permet un collage aisé du composant sur le circuit imprimé.

La fabrication de ces composants de section rectangulaire fait appel, toutefois, à une technologie différente de celle, plus ancienne, des composants du type cylindrique et requiert du fabricant de composants de faire des investissements très importants pour passer d'une technologie à l'autre.

Il serait donc très intéressant de pouvoir rendre les composants du type cylindrique utilisables dans les machines de report conçues pour les composants du type rectangulaire.

C'est ce que se propose de faire la présente invention.

Plus particulièrement, la présente invention concerne un composant électronique pour montage en surface, du type comprenant un corps cylindrique muni d'un capot conducteur à chacune de ses extrémités, caractérisé en ce qu'il comprend en outre un surmoulage partiel enrobant la partie du corps situé entre les capots conducteurs et laissant à nu au moins une partie de chaque capot conducteur, ce surmoulage présentant au moins deux facettes planes parallèles entre elles et à l'axe longitudinal dudit corps.

Selon un mode de réalisation particulier, le surmoulage enrobe seulement la partie du corps située entre les capots conducteurs.

Le surmoulage peut présenter, par exemple, une forme parallélépipédique ou prismatique.

L'une des facettes planes parallèles est destinée à permettre la préhension du composant par une pipette d'aspiration de report, tandis que l'autre permet de coller facilement le composant sur le panneau de circuit imprimé.

Le composant électronique peut être une résistance électrique, un condensateur, une self, une diode, etc... L'invention est d'un intérêt particulier dans le cas des résistances électriques miniatures et l'invention sera décrite plus précisément à propos de telles résistances bien que n'étant pas limitée à celles-ci.

Le surmoulage partiel peut être effectué par injection en utilisant des matériaux polymères résistant aux températures élevées de façon à permettre la soudure du composant par immersion dans une vague de soudure. Partant d'une ébauche de résistance miniature cylindrique à couche métallique spiralée, on peut aboutir de la sorte à une résistance pour montage en surface de semi-précision, c'est-à-dire ayant un coefficient de température de 25, 50 ou 100 ppm ou 0,0025 %, 0,005 % ou 0,01 % par degré centigrade, avec des tolérances comprises entre 0,25 % et 1 %.

A titre indicatif, on a pu réaliser un surmoulage par injection satisfaisant en utilisant un moule du type à deux plaques et à six cavités. Son alimentation se faisait dans la partie inférieure du moule. L'éjection mécanique à commande hydraulique était localisée à la base de la plaque inférieure.

La pose des inserts (ébauches de résistance à surmouler) s'effectuait sur le demi-berceau inférieur et la fermeture était faite par le demi-berceau supérieur. L'insert était positionné horizontalement.

La température du moule était régulée par une circulation d'huile maintenue entre 120 et 150°C. Cette régulation concernait les deux parties du moule. La température de plastification du matériau thermoplastique se situait entre 275°C (haut du cylindre) et 330°C (bas du cylindre). La pression d'injection était comprise entre 500 et 1000 bars.

Le procédé faisait appel à une presse à micro-injection par piston. La durée de l'injection était d'environ 4 secondes, et le temps de refroidissement d'environ 5 secondes.

La plupart des essais effectués par la Demanderesse ont été conduits en utilisant une variété de polysulfure de phénylène du type RYTON® BR 61 de la PHILLIPS PETROLEUM COMPANY.

Des essais satisfaisants ont également été effectués en utilisant du polyétherimide de la General Electric Plastics Europe - gamme des ULTEM®.

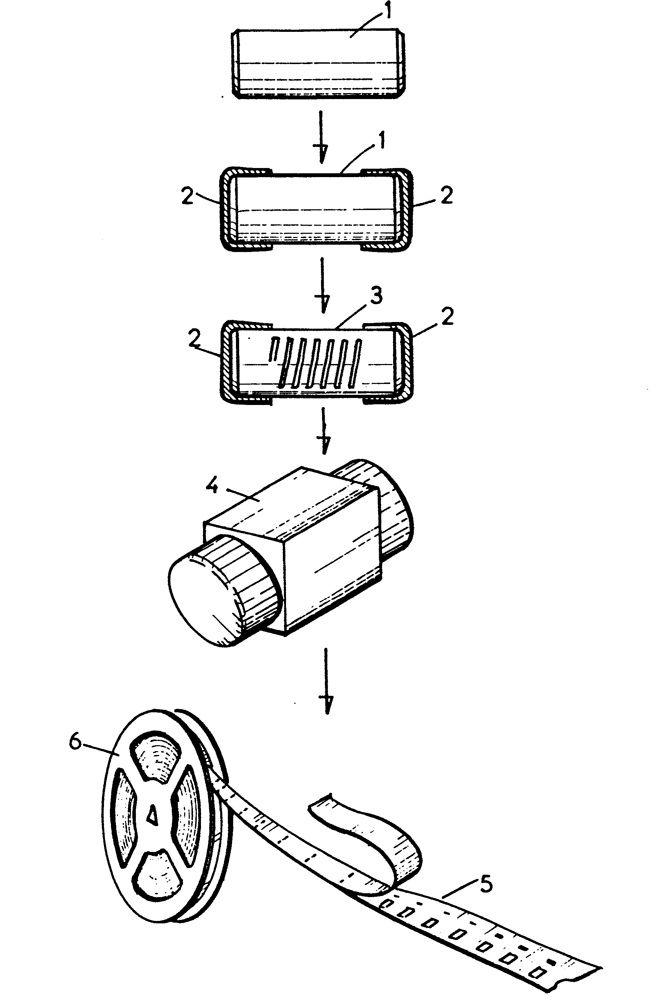

La description qui va suivre en regard du dessin annexé, donné à titre d'exemple non limitatif, fera bien comprendre comment l'invention peut être réalisée.

La figure unique illustre schématiquement la fabrication d'une résistance conforme à la présente invention.

On voit en 1 l'ébauche de résistance originelle constituée d'un substrat d'alumine recouvert d'une couche résistive de nickel-chrome déposée sous vide. Le capotage de cette ébauche s'effectue à l'aide de capots cylindriques 2 en maillechort argenté ou nickelé. Après capotage, la valeur ohmique demandée est obtenue par spiralage laser 3, procurant la résistance désirée.

Celle-ci est alors surmoulée partiellement par injection de résine thermoplastique, comme on l'a dit plus haut, pour former une pièce parallélépipédique 4, puis marquée éventuellement par un procédé laser ou d'impression par transfert.

Après contrôle de la valeur nominale à 100 %, les résistances sont mises sur bande 5 de format 8 mm, enroulée sur bobine 6.

Il va de soi que le mode de réalisation décrit n'est qu'un exemple et qu'on pourrait le modifier, notamment par substitution d'équivalents techniques, sans sortir pour cela du cadre de l'invention.

REVENDICATIONS

1. Un composant électronique pour montage en surface, du type comprenant un corps cylindrique muni d'un capot conducteur à chacune de ses extrémités, caractérisé en ce qu'il comprend en outre un surmoulage partiel enrobant la partie du corps située entre les capots conducteurs et laissant à nu au moins une partie de chaque capot conducteur, ce surmoulage présentant au moins deux facettes planes parallèles entre elles et à l'axe longitudinal dudit corps.

2. Un composant électronique selon la revendication 1, caractérisé en ce que le surmoulage enrobe seulement la partie du corps située entre les capots conducteurs.

3. Un composant électronique selon la revendication 1 ou 2, caractérisé en ce que le surmoulage présente une forme parallélépipédique ou prismatique.

4. Un composant électronique selon la revendication 1, 2 ou 3, caractérisé en ce que le surmoulage est réalisé en un matériau polymère thermoplastique résistant à la température d'une vague de soudure.

5. Un composant électronique selon l'une quelconque des revendications 1 à 4, caractérisé en ce qu'il est une résistance électrique miniature.

6. Bande portant une succession de composants électroniques selon l'une quelconque des revendications 1 à 5.

7. Procédé pour permettre le montage à plat sur un circuit électronique d'un composant électronique comprenant un corps cylindrique muni d'un capot conducteur à chacune de ses extrémités, à l'aide de certaines machines automatiques, caractérisé en ce qu'on effectue un surmoulage partiel enrobant la partie du corps située entre les capots conducteurs et laissant à nu au moins une partie de chaque capot conducteur, ce surmoulage présentant au moins deux facettes planes parallèles entre elles et à l'axe longitudinal dudit corps.

8. Procédé selon la revendication 7, caractérisé en ce qu'on réalise le surmoulage en injectant sous pression une résine thermoplastique à hautes performances thermiques dans un moule dans lequel le composant à surmouler a été préalablement disposé à titre d'insert.

1_1

0188152

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | DE-C- 968 665 (FELTEN & GUILLEAUME) <br> * Page 2, lignes 67-75; figure 3 * | 1 | H 05 K 13/00 <br> H 01 C 13/02 <br> H 01 G 1/035 |
| A | | 3,4,8 | |
| Y | --- <br> ELECTRONIC ENGINEERING, vol. 54, no. 666, juin 1982, pages 154-156, Londres, GB; "Technology focus; surface mounting on PCB's" <br> * Page 154, tableau 1 * | 1 | |
| A | IDEM | 2,5,7 | |
| A | --- <br> FR-A-1 495 139 (GENERAL ELECTRIC CO.) <br> * Page 2, colonne de droite, alinéa 2; figure 3 * | 1 | |
| A | --- <br> FR-A-2 385 203 (NOVI) <br> * Page 8, lignes 11-15, 33-40; page 9, ligne 1; figures 3-6 * <br><br> --- -/- | 1 | DOMAINES TECHNIQUES RECHERCHES (Int. Cl.4) <br><br> H 05 K <br> H 01 C <br> H 01 G <br> B 29 C |

Le présent rapport de recherche a été etabli pour toutes les revendications

| Lieu de la recherche <br> LA HAYE | Date d'achèvement de la recherche <br> 20-03-1986 | Examinateur <br> LOMMEL A. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82

## 0188152

Numéro de la demande

**RAPPORT DE RECHERCHE EUROPEENNE**

Office européen
des brevets

EP 85 40 2466

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int Cl 4) |
|---|---|---|---|
| A | JOURNAL OF ELECTRONIC ENGINEERING, vol. 17, no. 165, septembre 1980, pages 64-67, Tokyo, JP; T. INOUE: "Fixed resistors show new life" * Page 65, colonne de gauche, alinéa 2; figure 2 * | 1,6,7 | |
| | --- | | |
| A | FR-A-2 445 273 (MURATA) * Page 1, lignes 3-14; figure 6A * | 6 | |
| | ----- | | |

DOMAINES TECHNIQUES RECHERCHES (Int. Cl.4)

Le present rapport de recherche a ete etabli pour toutes les revendications

| Lieu de la recherche | Date d'achevement de la recherche | Examinateur |
|---|---|---|
| LA HAYE | 20-03-1986 | LOMMEL A. |